# FASCICULE DE BREVET EUROPEEN

(11) **EP 3 304 717 B1**
(45) Date de publication et mention de la délivrance du brevet: **08.01.2020**
(21) Numéro de dépôt: 16741050.5
(22) Date de dépôt: 26.05.2016
(51) Int. Cl.: H02M 3/158, H02M 1/08, H03K 17/687

(54) **BLOC CONVERTISSEUR CONTINU-CONTINU, CONVERTISSEUR CONTINU-CONTINU LE COMPRENANT ET SYSTÈME DE SUIVI D'ENVELOPPE ASSOCIÉ**
GLEICHSTROMWANDLERBLOCK, GLEICHSTROMWANDLER DAMIT UND ZUGEHÖRIGES SYSTEMHÜLLKURVENNACHFÜHRUNGSSYSTEM
DC-DC CONVERTER BLOCK, DC-DC CONVERTER COMPRISING SAME AND ASSOCIATED SYSTEM ENVELOPE TRACKING SYSTEM

(30) Priorité: 29.05.2015 FR 1554917
(43) Date de publication de la demande: 11.04.2018
(73) Titulaire: Wupatec, 87000 Limoges (FR)
(72) Inventeur: GATARD, Emmanuel, 87350 Panazol (FR); LACHAUD, Pierre, 87590 Saint Just Le Martel (FR)
(74) Mandataire: Cabinet Chaillot
(86) Numéro de dépôt international: PCT/FR2016/051240
(87) Numéro de publication internationale: WO 2016/193578

(56) Documents cités:
- WO-A1-2009/088391
- US-A1- 2012 062 323

## Description

La présente invention concerne le domaine des convertisseurs continu-continu, et porte en particulier sur un bloc convertisseur continu-continu forte puissance et hautes fréquences pour la technique de suivi d'enveloppe, sur un convertisseur continu-continu le comprenant et sur un système de suivi d'enveloppe associé.

L'augmentation constante des débits de communication sans fil nécessite l'utilisation de modulations complexes à efficacité spectrale élevée telles que l'OFDM (multiplexage par répartition orthogonale de la fréquence), ces modulations présentant des facteurs de crête importants (rapport entre la puissance crête et la puissance moyenne du signal).

Les amplificateurs de puissance RF qui sont alimentés par une tension d'alimentation continue fournissent un rendement maximal uniquement lorsqu'ils travaillent à la compression, c'est-à-dire à la puissance crête du signal à émettre. Cependant, la plupart du temps, l'amplificateur fournit une puissance bien inférieure à sa puissance maximale, proche de la puissance moyenne du signal à émettre, le rendement de l'amplificateur étant dans ces conditions bien inférieur à son rendement maximal.

La technique de suivi d'enveloppe (en anglais, « Envelope Tracking ») est une technique d'alimentation pour améliorer le rendement des amplificateurs de puissance RF, celle-ci remplaçant l'alimentation constante continue de l'amplificateur par une alimentation dynamique continue qui suit l'amplitude du signal RF à émettre. La technique de suivi d'enveloppe permet d'ajuster dynamiquement la tension d'alimentation de l'amplificateur de puissance RF afin que celui-ci fonctionne toujours en compression et donc à son rendement maximal, quel que soit le niveau de puissance de l'enveloppe du signal RF, cette technique permettant pour les formats de modulation modernes d'améliorer significativement le rendement des amplificateurs de puissance RF tout en répondant aux exigences des normes en termes de linéarité.

Dans le cas d'un amplificateur de puissance RF à suivi d'enveloppe, la tension d'alimentation est par définition constamment réajustée afin de s'assurer que l'amplificateur fonctionne toujours à la compression et donc à son rendement maximal, quel que soit le niveau de puissance souhaité à l'émission.

La tension d'alimentation d'un amplificateur de puissance RF à suivi d'enveloppe est généralement générée par un convertisseur continu-continu hybride (également appelé modulateur de polarisation) permettant de générer un signal de commande continu large bande. Le convertisseur continu-continu hybride comprend une partie convertisseur continu-continu à fort rendement en commutation pure fonctionnant à basses fréquences et une partie amplification linéaire permettant de suivre les variations rapides du signal d'enveloppe. Cependant, la partie amplification linéaire qui présente un faible rendement dégrade fortement le rendement global du convertisseur continu-continu hybride. En outre, plus la bande passante couverte par la partie amplification linéaire est importante, plus le rendement global est impacté par le faible rendement de la partie amplification linéaire.

Une autre technique connue communément utilisée pour générer un signal de commande continu de suivi d'enveloppe s'appuie uniquement sur l'utilisation seule d'un convertisseur continu-continu en commutation, celui-ci devant être suffisamment rapide afin de répondre aux exigences en termes de bande passante étant donné qu'il s'appuie sur un signal de découpe de type PWM (modulation d'impulsions en largeur) ou sigma-delta. Cependant ce type de convertisseur s'avère relativement limité en bande passante pour supporter la technique de suivi d'enveloppe. Des architectures de convertisseur continu-continu en commutation de type multi-phase permettent d'améliorer les bandes passantes des convertisseurs sans pour autant atteindre une rupture technologique en termes de rendement et bande passante.

La conversion continu-continu large bande et à fort rendement repose sur des convertisseurs à découpage quel que soit le type de modulateur : hybride ou à commutation seule. Ces convertisseurs s'appuient directement sur des topologies et des technologies utilisées traditionnellement pour la conversion de tension d'alimentation.

Ces convertisseurs, basés principalement sur des architectures de type abaisseur de tension (en anglais, « Buck ») ou amplificateur de tension (en anglais, « Boost »), utilisent des transistors de type MOSFET (transistor à effet de champ métal-oxyde-semi-conducteur) en technologie au silicium qui présentent l'avantage d'être largement éprouvés et d'être disponibles en technologies complémentaires (à canal N ou P), les grilles des transistors MOSFET étant généralement pilotées par des circuits intégrés sur silicium mettant en œuvre la technique de « Bootstrap » (d'amorçage).

Cependant, les transistors MOSFET en technologie au silicium s'avèrent très limités en fréquence de commutation pour des applications de forte puissance. La réponse à cette problématique passe nécessairement par l'utilisation de nouveaux matériaux tels que le nitrure de gallium (GaN). Pour un tel matériau, des transistors de type HEMT (transistor à haute mobilité d'électrons) à enrichissement (normalement ouverts) ou HEMT à déplétion (normalement fermés) existent à partir de processus de fabrication différents. Ils permettent d'atteindre des fréquences de fonctionnement plus importantes mais utilisent des dispositifs de pilotage de grille de type « Bootstrap » toujours en technologie au silicium. Par ailleurs, l'utilisation de transistors HEMT à déplétion (normalement fermés) conjointement à un dispositif de pilotage de grille de type « Bootstrap » pose un problème évident lors de la phase de démarrage du circuit, le dispositif de pilotage de grille de type « Bootstrap » imposant de continuellement commuter les transistors.

Les fabricants d'alimentations à découpage se tournent donc vers des transistors de type HEMT à enrichissement en technologie GaN pilotés par des dispositifs de pilotage de type « Bootstrap » au silicium, ce type de transistor étant développé spécialement pour les applications de conversion de tension d'alimentation et permettant d'améliorer significativement les performances vis-à-vis des transistors MOSFET au silicium sans pour autant rivaliser avec les transistors HEMT à déplétion utilisés traditionnellement dans des applications d'amplification à très hautes fréquences.

L'augmentation constante des bandes passantes de modulation nécessite donc, quelle que soit l'architecture du modulateur de polarisation utilisée, de disposer de convertisseurs continu-continu capables de fonctionner à des fréquences de commutation très élevées, ces fréquences étant bien supérieures à ce que les technologies disponibles de convertisseurs continu-continu peuvent permettre, notamment dans le cas d'applications de forte puissance.

Les transistors HEMT à déplétion (normalement fermés) en technologie GaN, généralement utilisés pour des applications d'amplification en hyperfréquences, permettent d'atteindre potentiellement des fréquences de fonctionnement très élevées. Cependant, ni les dispositifs de pilotage de grille de type « Bootstrap » au silicium, ni les topologies existantes des convertisseurs continu-continu ne permettent d'utiliser réellement ce type de composant pour des applications d'alimentation à découpage ou au sein de convertisseurs continu-continu très hautes fréquences de type abaisseur de tension pour la technique de suivi d'enveloppe. <Insérer la page 5A>

La présente invention selon la revendication 1 vise à résoudre les inconvénients de l'état antérieur de la technique, en proposant un bloc convertisseur continu-continu forte puissance et hautes fréquences pour la technique de suivi d'enveloppe pour des applications d'amplification radiofréquence et/ou hyperfréquence de forte puissance afin de permettre une rupture technologique concernant la limitation rendement-bande passante imposée par les convertisseurs continu-continu existants qui rendait jusqu'à maintenant la technique de suivi d'enveloppe difficilement applicable pour les applications de forte puissance avec des débits élevés, ledit bloc convertisseur continu-continu selon la présente invention comprenant un circuit de puissance abaisseur de tension avec au moins un transistor HEMT à déplétion et un circuit de pilotage avec des transistors HEMT à déplétion, le circuit de puissance étant alimenté par deux tensions d'alimentation positives et non nulles.

La demande de brevet américain US2012/062323A1 décrit un amplificateur de puissance radiofréquence à suivi d'enveloppe comprenant un dispositif d'amplification RF de puissance et un convertisseur continu-continu dont le circuit de puissance comprend des transistors HEMT. Cependant, dans ce convertisseur continu-continu, le circuit de pilotage du circuit de puissance n'est pas approprié pour de très hautes fréquences de commutation, et, en outre, ce circuit ne permet pas de rendre significativement minimales les pertes lors des phases de commutation du convertisseur continu-continu.

La demande internationale PCT WO2009/088391A1 décrit un circuit intégré comprenant un étage de puissance et un étage de pilotage, les étages de puissance et de pilotage utilisant des dispositifs de puissance au nitrure du groupe III. Cependant, ce circuit n'est pas destiné à la technique de suivi d'enveloppe, et, en outre, ce circuit ne permet pas de rendre significativement minimales les pertes lors des phases de commutation du convertisseur continu-continu.

La présente invention propose également un convertisseur continu-continu comprenant le bloc convertisseur continu-continu et un système pour la technique de suivi d'enveloppe comprenant un convertisseur continu-continu pour la technique de suivi d'enveloppe selon la présente invention et un amplificateur radiofréquence (RF) de puissance.

La présente invention a donc pour objet un bloc convertisseur continu-continu pour la technique de suivi d'enveloppe comprenant un circuit de puissance abaisseur de tension dont la sortie constitue la sortie du bloc convertisseur continu-continu configurée pour être reliée à une entrée de tension d'alimentation d'un amplificateur radiofréquence, RF, de puissance, le circuit de puissance abaisseur de tension comprenant au moins un transistor HEMT (à haute mobilité d'électrons) à déplétion, le bloc convertisseur continu-continu comprenant en outre un circuit de pilotage de grille de l'au moins un transistor HEMT à déplétion du circuit de puissance abaisseur de tension, caractérisé par le fait que le circuit de pilotage comprend des transistors HEMT à déplétion configurés pour piloter la grille de l'au moins un transistor HEMT à déplétion du circuit de puissance abaisseur de tension, et par le fait que le circuit de puissance abaisseur de tension est alimenté par deux tensions d'alimentation référencées à la masse, positives et non nulles, à savoir une première tension d'alimentation et une seconde tension d'alimentation, la première tension d'alimentation étant supérieure à la seconde tension d'alimentation.

Par forte puissance, on entend des puissances supérieures à 1W.

Par hautes fréquences, on entend des fréquences de commutation supérieures à 10MHz.

Ainsi, le bloc convertisseur continu-continu est spécialement approprié pour la technique de suivi d'enveloppe, les transistors hyperfréquences de type HEMT à déplétion (dits normalement fermés) étant spécifiquement appropriés pour des applications de forte puissance avec des fréquences de commutation élevées.

Différentes technologies de semi-conducteurs peuvent être utilisés pour la réalisation des transistors HEMT à déplétion, ces matériaux étant principalement le nitrure de gallium (GaN) et l'arséniure de gallium (GaAs) mais aussi tout autre matériau semi-conducteur à base de matériaux du groupe III-V tels que AlGaN, AlN, InAlN, InAlGaN, etc.

L'utilisation de transistors RF et hyperfréquence de type HEMT à déplétion offre un fort potentiel en termes de fréquence de fonctionnement de par leurs très faibles capacités parasites, ce type de transistors permettant traditionnellement d'adresser des fonctions d'amplification de puissance jusqu'à plusieurs dizaines de gigahertz, ce type de transistor offrant en outre les avantages d'être disponible suivant différents développements de grille et d'être très facilement intégrable dans des circuits monolithiques MMIC (circuits intégrés monolithiques hyperfréquences).

De plus, les très faibles capacités parasites de ces transistors HEMT à déplétion associées à des tensions de claquage élevées rendent ce type de composants particulièrement adapté aux applications de conversion continu-continu large bande de forte puissance (> 1W).

Les transistors HEMT à déplétion présentent en outre l'avantage d'être utilisables en conduction directe et inverse. Ils ne nécessitent donc pas nécessairement de diodes Schottky placées en parallèle pour la gestion des courants inverses, ce qui permet de rendre minimales les capacités parasites et donc d'atteindre des fréquences de commutation plus importantes.

Le circuit de pilotage de grille est intégré au bloc convertisseur continu-continu dans la même technologie, c'est-à-dire comprenant des transistors HEMT à déplétion, ce qui permet d'obtenir un circuit de pilotage de grille ultra rapide et à faible consommation.

L'architecture du bloc convertisseur continu-continu avec un circuit de puissance de type abaisseur de tension est particulièrement optimisée pour la technique de suivi d'enveloppe à travers l'utilisation de deux tensions d'alimentation qui bornent la tension générée par le bloc convertisseur continu-continu, ce qui permet de rendre significativement minimales les pertes lors des phases de commutation du bloc convertisseur continu-continu, la première tension d'alimentation devant être supérieure à la seconde tension d'alimentation afin de veiller au bon fonctionnement du bloc convertisseur continu-continu.

De plus, l'utilisation d'un circuit de puissance de type abaisseur de tension présente également l'avantage d'une simplicité de pilotage dans le cas d'une utilisation pour la technique de suivi d'enveloppe. En effet, le circuit de puissance de type abaisseur de tension est plus simple à commander qu'un circuit de puissance de type amplificateur de tension car aisément utilisable sans chaîne de contre-réaction même dans le cas où il est confronté à des variations d'impédance de charge ou pire à l'absence de charge.

Selon un premier mode de réalisation de l'invention, le circuit de puissance abaisseur de tension est de type asynchrone et comprend un transistor de puissance HEMT à déplétion et une diode de puissance Schottky, la borne d'entrée de conduction du transistor de puissance étant connectée à la première tension d'alimentation, l'anode de la diode de puissance étant connectée à la seconde tension d'alimentation, la sortie du circuit de puissance abaisseur de tension étant connectée à la borne de sortie de conduction du transistor de puissance et à la cathode de la diode de puissance, et la grille du transistor de puissance étant connectée au circuit de pilotage du bloc convertisseur continu-continu, de telle sorte que la tension de sortie du circuit de puissance abaisseur de tension du bloc convertisseur continu-continu est bornée par les première et seconde tensions d'alimentation.

Les transistors de puissance HEMT peuvent fonctionner en conduction directe (quadrant (V_{ds}, I_{ds}) > 0) ou inverse (quadrant (V_{ds}, I_{ds}) < 0). En conduction directe, la borne d'entrée de conduction est le drain et la borne de sortie de conduction est la source. En conduction inverse, la borne d'entrée de conduction est la source et la borne de sortie de conduction est le drain.

Ainsi, lorsque le circuit de pilotage pilote la grille du transistor de puissance afin d'ouvrir ce dernier, la tension de sortie du circuit de puissance abaisseur de tension est égale à la seconde tension d'alimentation, et lorsque le circuit de pilotage pilote la grille du transistor de puissance afin de fermer ce dernier, la tension de sortie du circuit de puissance abaisseur de tension est égale à la première tension d'alimentation, la tension de sortie du circuit de puissance abaisseur de tension du bloc convertisseur continu-continu étant ainsi bornée par les première et seconde tensions d'alimentation.

La diode de puissance peut être de type Schottky en technologie Si, SiC, GaAs ou GaN mais peut être également basée sur des matériaux semi-conducteurs à base de matériaux du groupe III-V tels que AlGaN, AlN, InAlN, InAlGaN, etc.

Selon un second mode de réalisation de l'invention, le circuit de puissance abaisseur de tension est de type synchrone et comprend un premier transistor de puissance HEMT à déplétion et un second transistor de puissance HEMT à déplétion, la borne d'entrée de conduction du premier transistor de puissance étant connectée à la première tension d'alimentation, la borne de sortie de conduction du second transistor de puissance étant connectée à la seconde tension d'alimentation, la sortie du circuit de puissance abaisseur de tension étant connectée à la borne de sortie de conduction du premier transistor de puissance et à la borne d'entrée de conduction du second transistor de puissance, et les grilles des premier et second transistors de puissance étant connectées au circuit de pilotage du bloc convertisseur continu-continu, de telle sorte que la tension de sortie du circuit de puissance abaisseur de tension du bloc convertisseur continu-continu est bornée par les première et seconde tensions d'alimentation.

Ainsi, lorsque le circuit de pilotage pilote la grille du premier transistor de puissance afin de fermer ce dernier et la grille du second transistor de puissance afin d'ouvrir ce dernier, la tension de sortie du circuit de puissance abaisseur de tension est égale à la première tension d'alimentation, et lorsque le circuit de pilotage pilote la grille du premier transistor de puissance afin d'ouvrir ce dernier et la grille du second transistor de puissance afin de fermer ce dernier, la tension de sortie du circuit de puissance abaisseur de tension est égale à la seconde tension d'alimentation, la tension de sortie du circuit de puissance abaisseur de tension du bloc convertisseur continu-continu étant ainsi bornée par les première et seconde tensions d'alimentation.

Contrairement au circuit de puissance abaisseur de tension de type asynchrone dans lequel la diode de puissance peut s'avérer dans certains cas comme un élément limitant les performances du bloc convertisseur continu-continu, ladite diode de puissance devant présenter à la fois une très faible chute de tension et une très faible valeur de capacité parasite, le circuit de puissance abaisseur de tension de type synchrone utilise, à la place de la diode de puissance, un second transistor de puissance HEMT à déplétion, ce qui permet de bénéficier des avantages du transistor pour lequel la chute de tension est directement proportionnelle au courant le traversant.

Selon une caractéristique particulière de l'invention, le bloc convertisseur continu-continu comprend en outre des condensateurs de découplage d'alimentation respectivement disposés en parallèle des première et seconde tensions d'alimentation.

Ainsi, les condensateurs de découplage d'alimentation permettent d'assurer la stabilité des transistors HEMT hautes fréquences et de filtrer des parasites présents dans les tensions d'alimentation.

Selon une caractéristique particulière de l'invention, le circuit de pilotage comprend, pour chaque grille de transistor HEMT à déplétion du circuit de puissance abaisseur de tension à piloter, un premier transistor de pilotage HEMT à déplétion, un second transistor de pilotage HEMT à déplétion, des première, seconde et troisième résistances, une diode Schottky et une tension d'alimentation auxiliaire, la source du premier transistor de pilotage étant connectée à la masse, le drain du premier transistor de pilotage étant connecté à l'une des bornes de la première résistance et à l'une des bornes de la seconde résistance, la grille du premier transistor de pilotage étant connectée à une entrée correspondante du circuit de pilotage, la grille du second transistor de pilotage étant connectée à l'autre des bornes de la première résistance, la source du second transistor de pilotage étant connectée à l'autre des bornes de la seconde résistance, à la cathode de la diode Schottky et à l'une des bornes de la troisième résistance, l'anode de la diode Schottky étant connectée à la tension d'alimentation auxiliaire, l'autre des bornes de la troisième résistance étant connecté à la grille du transistor HEMT à déplétion du circuit de puissance abaisseur de tension à piloter correspondant, le drain du second transistor de pilotage étant connecté à la première tension d'alimentation si celle-ci est connectée à la borne d'entrée de conduction du transistor HEMT à déplétion du circuit de puissance abaisseur de tension à piloter correspondant ou étant connectée à la seconde tension d'alimentation si celle-ci est connectée à la borne de sortie de conduction du transistor HEMT à déplétion du circuit de puissance abaisseur de tension à piloter correspondant, la tension d'alimentation auxiliaire étant supérieure à la tension de pincement du second transistor de pilotage, et la seconde tension d'alimentation étant supérieure à la tension d'alimentation auxiliaire plus la tension de pincement du transistor HEMT à déplétion du circuit de puissance abaisseur de tension à piloter correspondant.

Ainsi, cette topologie spécifique du circuit de pilotage permet de rendre minimales les pertes par commutation du bloc convertisseur continu-continu.

Chaque diode Schottky du circuit de pilotage peut être en technologie Si, SiC, GaAs ou GaN mais peut être également basée sur des matériaux semi-conducteurs à base de matériaux du groupe III-V tels que AlGaN, AlN, InAlN, InAlGaN, etc.

L'architecture du circuit de pilotage de grille du ou des transistors de puissance rend le bloc convertisseur continu-continu extrêmement flexible en fréquence. En effet, le circuit de pilotage de grille du ou des transistors de puissance étant couplé en courant continu, il n'existe aucune limitation en termes de fréquences minimale et maximale de commutation, la fréquence maximale de commutation étant en réalité limitée par la seconde résistance du circuit de pilotage, par la capacité grille-source (C_{GS}) du second transistor de pilotage du circuit de pilotage et par les performances des transistors HEMT à déplétion eux-mêmes.

L'architecture spécifique du circuit de pilotage de grille, permet ainsi d'atteindre des vitesses de commutation très importantes.

De plus, pour chaque transistor HEMT à déplétion du circuit de puissance abaisseur de tension à piloter, la partie du circuit de pilotage associée au transistor de puissance à piloter correspondant présente une consommation nulle lorsqu'elle rend le transistor de puissance correspondant passant et consomme très peu de puissance lorsque le transistor de puissance correspondant est bloqué, grâce à l'utilisation d'une alimentation auxiliaire et de la diode disposée en sortie de cette alimentation auxiliaire.

La tension d'alimentation auxiliaire doit être supérieure à la tension de pincement du second transistor de pilotage afin que celui-ci puisse se bloquer, et la seconde tension d'alimentation doit être supérieure à la tension d'alimentation auxiliaire plus la tension de pincement du transistor HEMT à déplétion du circuit de puissance abaisseur de tension à piloter correspondant afin que le transistor HEMT à déplétion correspondant du circuit de puissance abaisseur de tension puisse se bloquer.

Les première et troisième résistances sont des résistances de stabilisation permettant de contrôler le risque d'oscillation des transistors HEMT à déplétion présentant des gains très importants.

La seconde résistance influe directement sur la vitesse de commutation du circuit de pilotage de grille, une valeur de seconde résistance plus faible conduisant, pour un développement de grille de second transistor de pilotage donné, à une vitesse de commutation accrue mais impliquant alors une consommation électrique plus importante lorsque le transistor de puissance à piloter est bloqué, un compromis entre vitesse et consommation du circuit de pilotage existant donc pour un développement de grille de second transistor de pilotage donné.

Il est à noter que, lorsque le circuit de puissance abaisseur de tension du bloc convertisseur continu-continu est de type asynchrone, le circuit de pilotage comprend une partie unique de pilotage de grille de transistor de puissance, et lorsque le circuit de puissance abaisseur de tension du bloc convertisseur continu-continu est de type synchrone, le circuit de pilotage comprend deux parties de pilotage de grille de transistor de puissance pilotant respectivement les grilles des deux transistors de puissance.

Selon une caractéristique particulière de l'invention, chaque tension d'entrée au niveau d'une entrée correspondante du circuit de pilotage est négative et comprise entre 0 V et -Vp, Vp étant la tension de pincement du transistor de pilotage dont la grille est connectée à ladite entrée correspondante du circuit de pilotage, ladite tension d'entrée étant délivrée par un circuit d'interface relié à un circuit numérique de commande PWM (modulation d'impulsions en largeur) ou sigma-delta.

Ainsi, dans ces conditions de fonctionnement propres à la technique de suivi d'enveloppe, l'utilisation de rapports cycliques de commande numérique variant sur toute la gamme possible, c'est-à-dire de 0% à 100%, permet de rendre minimale la récurrence des commutations à effectuer et ainsi de rendre maximal le rendement du bloc convertisseur continu-continu.

Le circuit numérique de commande est l'un parmi un processeur de signal numérique (DSP), une matrice prédiffusée programmable par l'utilisateur (FPGA), un circuit intégré spécifique (ASIC) ou tout autre circuit numérique permettant de piloter le bloc convertisseur continu-continu.

Le circuit d'interface permet de fournir chaque tension d'entrée au circuit de pilotage à partir de la commande numérique fournie par le circuit numérique de commande.

Selon une caractéristique particulière de l'invention, lorsque le circuit de puissance abaisseur de tension est de type synchrone, les deux tensions d'entrée du circuit de pilotage sont complémentaires.

Ainsi, les pilotages des deux transistors de puissance sont complémentaires, de telle sorte que l'un des deux transistors de puissance est fermé lorsque l'autre des deux transistors de puissance est ouvert, et inversement.

Il est à noter que le circuit numérique de commande est configuré pour compenser les différences de temps de montée et de descente, aussi appelées temps morts, entre les deux transistors de puissance à piloter.

Selon une caractéristique particulière de l'invention, les tailles de grille des transistors HEMT à déplétion du circuit de pilotage sont inférieures à celles du ou des transistors HEMT à déplétion du circuit de puissance abaisseur de tension.

Ceci a pour avantage de rendre significativement minimale la capacité parasite (C_{GS}) du second transistor de pilotage et donc de permettre d'utiliser des valeurs de seconde résistance suffisamment grandes pour que le circuit de pilotage consomme peu de puissance.

Selon une première variante de l'invention, tous les composants du bloc convertisseur continu-continu sont des composants discrets montés sur une carte à circuits imprimés ou liés à celle-ci par des fils de liaison. Dans ce dernier cas, le circuit est dit « hybride ».

Ainsi, le bloc convertisseur continu-continu peut être réalisé à partir de composants discrets tels que des transistors, des diodes, des résistances et des condensateurs en boîtier.

Il peut également être réalisé à partir de composants en puce dans un circuit hybride.

Selon une seconde variante de l'invention, tous les composants du bloc convertisseur continu-continu sont intégrés de manière monolithique dans un circuit intégré.

Ainsi, ceci permet l'intégration du bloc convertisseur continu-continu et d'un amplificateur RF de puissance alimenté par le bloc convertisseur continu-continu dans une même technologie et donc intégrés sur une même puce, cette intégration pouvant directement être réalisée de manière monolithique dans un circuit de type MMIC afin d'augmenter l'intégration du bloc convertisseur continu-continu.

Le circuit électronique peut également comprendre, si besoin, un amplificateur linéaire qui sera alors associé au bloc convertisseur continu-continu.

Dans le cas d'une réalisation de type MMIC, l'amplificateur linéaire peut être intégré sur le MMIC.

Selon une caractéristique particulière de l'invention, les transistors HEMT du circuit de puissance abaisseur de tension et les transistors HEMT du circuit de pilotage sont en l'un quelconque parmi le nitrure de gallium (GaN), l'arséniure de gallium (GaAs) ou en tout autre matériau semi-conducteur à base de matériaux de type III-V.

Selon une caractéristique particulière de l'invention, les diodes sont de type Schottky en technologie Si, SiC, GaAs, GaN ou en tout autre matériau semi-conducteur à base de matériaux de type III-V.

De plus, dans le cas d'une intégration monolithique de l'amplificateur RF de puissance et du bloc convertisseur continu-continu, la technologie des transistors étant identique, les contraintes de tenue en tension sont directement compatibles.

L'invention a également pour objet un convertisseur continu-continu forte puissance et hautes fréquences pour la technique de suivi d'enveloppe, caractérisé par le fait qu'il comprend un bloc convertisseur continu-continu tel que défini ci-dessus et un filtre de sortie connecté à la sortie du circuit de puissance abaisseur de tension du bloc convertisseur continu-continu, le filtre étant de préférence à base de condensateurs et d'inductances, la sortie du filtre de sortie constituant la sortie du convertisseur continu-continu forte puissance et hautes fréquences.

Ainsi, le filtre de sortie, constitué par exemple de condensateurs et d'inductances, permet de reconstruire le signal de polarisation à appliquer sur l'entrée de tension d'alimentation d'un amplificateur RF de puissance à partir d'un signal de commande numérique de type PWM (modulation d'impulsions en largeur) ou sigma-delta en utilisant des rapports cycliques de commande numérique variant sur toute la gamme possible, c'est-à-dire de 0% à 100%.

La présente invention a également pour objet un convertisseur continu-continu forte puissance et hautes fréquences pour la technique de suivi d'enveloppe de type multi-phase, caractérisé par le fait qu'il comprend au moins deux convertisseurs continu-continu tels que décrits précédemment montés en parallèle et alimentés par les mêmes tensions d'alimentation.

La présente invention a également pour objet un système pour la technique de suivi d'enveloppe comprenant un convertisseur continu-continu pour la technique de suivi d'enveloppe ou un convertisseur continu-continu pour la technique de suivi d'enveloppe de type multiphase selon la présente invention, un amplificateur radiofréquence (RF) de puissance et un circuit numérique de traitement de suivi d'enveloppe, le circuit numérique de traitement de suivi d'enveloppe commandant le convertisseur continu-continu et l'amplificateur RF de puissance, et la sortie du convertisseur continu-continu étant reliée à l'entrée de tension d'alimentation de l'amplificateur RF de puissance.

Les systèmes pour la technique de suivi d'enveloppe avec des convertisseurs continu-continu classiques sont décrits de manière générale, par exemple, dans la publication scientifique « Amplificateur de station de base à suivi d'enveloppe WCDMA à haute efficacité implémenté sur transistors bipolaires à hétérojonction haute tension à base de GaAs » ("High-Efficiency WCDMA Envelope Tracking Base-Station Amplifier Implemented With GaAs HVHBTs"), Jinseong Jeong; Kimball, D.F.; Myoungbo Kwak; Draxler, P.; Chin Hsia; Steinbeiser, C.; Landon, T.; Krutko, O.; Larson, L.E.; Asbeck, P.M., Solid-State Circuits, IEEE Journal of , vol.44, no.10, pp.2629,2639, Oct. 2009.

Ainsi, la première tension d'alimentation du convertisseur continu-continu correspond à la tension d'alimentation maximale de l'amplificateur RF de puissance lorsque celui-ci fournit une puissance de sortie maximale, et la seconde tension d'alimentation du convertisseur continu-continu correspond à la tension d'alimentation minimale de l'amplificateur RF de puissance lorsque sa puissance de sortie est faible. Les deux tensions d'alimentation sont donc choisies en fonction des caractéristiques électriques hyperfréquences de l'amplificateur RF de puissance à commander suivant la technique de suivi d'enveloppe.

Pour mieux illustrer l'objet de la présente invention, on va en décrire ci-après, à titre illustratif et non limitatif, deux modes de réalisation préférés, avec référence aux dessins annexés.

Sur ces dessins :
- la Figure 1 est un schéma de principe d'un convertisseur continu-continu pour la technique de suivi d'enveloppe selon un premier mode de réalisation de la présente invention ; et
- la Figure 2 est un schéma de principe d'un convertisseur continu-continu pour la technique de suivi d'enveloppe selon un deuxième mode de réalisation de la présente invention.

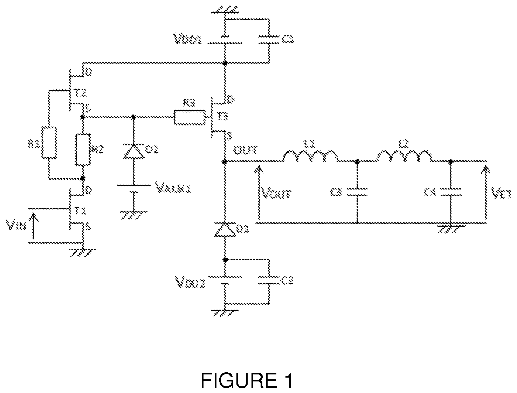

Si l'on se réfère à la Figure 1, on peut voir qu'il y est représenté un convertisseur continu-continu pour la technique de suivi d'enveloppe selon un premier mode de réalisation de la présente invention, comprenant un bloc convertisseur continu-continu et un filtre de sortie.

Le bloc convertisseur continu-continu pour la technique de suivi d'enveloppe comprend un circuit de puissance abaisseur de tension de type asynchrone alimenté par deux tensions d'alimentation positives et non nulles, à savoir une première tension d'alimentation VDD1 et une seconde tension d'alimentation VDD2, la première tension d'alimentation VDD1 étant supérieure à la seconde tension d'alimentation VDD2, et un circuit de pilotage du circuit de puissance abaisseur de tension.

Les première et seconde tensions d'alimentation VDD1 et VDD2 sont choisies en fonction des caractéristiques électriques hyperfréquences d'un amplificateur RF de puissance alimenté par le convertisseur continu-continu, et peuvent avoir, par exemple, respectivement des valeurs de 50 V et 10 V.

Le circuit de puissance abaisseur de tension comprend un transistor de puissance HEMT à déplétion T3 et une diode de puissance Schottky D1, le drain du transistor de puissance T3 étant connecté à la première tension d'alimentation VDD1, l'anode de la diode de puissance D1 étant connectée à la seconde tension d'alimentation VDD2, la sortie OUT du circuit de puissance abaisseur de tension étant connectée à la source du transistor de puissance T3 et à la cathode de la diode de puissance D1, et la grille du transistor de puissance T3 étant connectée au circuit de pilotage du bloc convertisseur continu-continu, de telle sorte que la tension de sortie V_{OUT} du circuit de puissance abaisseur de tension du bloc convertisseur continu-continu est bornée par les première et seconde tensions d'alimentation VDD1 et VDD2.

Le transistor de puissance T3 a, par exemple, une valeur de développement de grille de 10mm en technologie GaN et la diode de puissance D1 a, par exemple, un courant maximum admissible de 3A.

Le bloc convertisseur continu-continu comprend en outre des condensateurs de découplage d'alimentation C1 et C2 respectivement disposés en parallèle des première et seconde tensions d'alimentation VDD1 et VDD2.

Les condensateurs C1 et C2 ont, par exemple, respectivement des valeurs comprises entre 10pF et 1nF, l'homme du métier sachant ajuster les valeurs en fonction des autres composants et des caractéristiques requises.

Il est à noter que le bloc convertisseur continu-continu pourrait ne pas comprendre de condensateurs de découplage d'alimentation, sans s'écarter du cadre de la présente invention.

Il est à noter que le bloc convertisseur continu-continu pourrait ne pas comprendre de résistances de stabilisation (R1, R3, R4, R6).

Le convertisseur continu-continu comprend en outre un filtre de sortie connecté à la sortie OUT du circuit de puissance abaisseur de tension du bloc convertisseur continu-continu, le filtre de sortie comprenant deux inductances L1 et L2 et deux condensateurs C3 et C4, l'une des bornes de l'inductance L1 étant connectée à la sortie OUT du circuit de puissance abaisseur de tension du bloc convertisseur continu-continu, l'autre des bornes de l'inductance L1 étant connectée à l'une des bornes de l'inductance L2 et à l'une des bornes du condensateur C3, l'autre des bornes de l'inductance L2 étant connectée à l'une des bornes du condensateur C4, l'autre des bornes du condensateur C3 et l'autre des bornes du condensateur C4 étant connectées à la masse, et le signal de polarisation V_{ET} à appliquer sur l'entrée de tension de polarisation d'un amplificateur RF de puissance à alimenter étant prélevée au niveau de la connexion entre l'inductance L2 et le condensateur C4.

L'inductance L1, l'inductance L2, le condensateur C3 et le condensateur C4 ont, des valeurs déterminées par l'homme du métier en fonction des autres paramètres, notamment la bande passante du signal à transmettre, la fréquence de commutation, et la topologie du filtre.

Il est à noter que l'architecture du filtre de sortie est donnée ici à titre d'exemple et pourrait également prendre une quelconque autre architecture, sans s'écarter du cadre de la présente invention, ledit filtre de sortie étant, dans tous les cas, configuré pour reconstruire le signal de polarisation V_{ET} issu d'un signal numérique de commande de type PWM ou sigma-delta, le convertisseur continu-continu étant utilisé pour des rapports cycliques de commande PWM ou sigma-delta variant de 0% à 100%.

Le circuit de pilotage est configuré pour piloter la grille du transistor de puissance T3, et comprend un premier transistor de pilotage HEMT à déplétion T1, un second transistor de pilotage HEMT à déplétion T2, des première, seconde et troisième résistances R1, R2 et R3, une diode Schottky D2 et une tension d'alimentation auxiliaire V_{AUX1}, la source du premier transistor de pilotage T1 étant connectée à la masse, le drain du premier transistor de pilotage T1 étant connecté à l'une des bornes de la première résistance R1 et à l'une des bornes de la seconde résistance R2, la grille du premier transistor de pilotage T1 étant connectée à une entrée V_{IN1} du circuit de pilotage, la grille du second transistor de pilotage T2 étant connectée à l'autre des bornes de la première résistance R1, la source du second transistor de pilotage T2 étant connectée à l'autre des bornes de la seconde résistance R2, à la cathode de la diode Schottky D2 et à l'une des bornes de la troisième résistance R3, l'anode de la diode Schottky D2 étant connectée à la tension d'alimentation auxiliaire V_{AUX1}, l'autre des bornes de la troisième résistance R3 étant connectée à la grille du transistor HEMT à déplétion T3 du circuit de puissance abaisseur de tension, le drain du second transistor de pilotage T2 étant connecté à la première tension d'alimentation VDD1.

La tension d'alimentation auxiliaire V_{AUX1} est supérieure à la tension de pincement du second transistor de pilotage T2 afin que ce dernier puisse s'ouvrir, et la seconde tension d'alimentation VDD2 est supérieure à la tension d'alimentation auxiliaire V_{AUX1} plus la tension de pincement du transistor HEMT à déplétion T3 afin que ce dernier puisse s'ouvrir.

Les développements de grille des transistors HEMT à déplétion T1 et T2 du circuit de pilotage sont beaucoup plus faibles que celui du transistor HEMT à déplétion T3 du circuit de puissance abaisseur de tension. Les transistors de pilotage T1 et T2 ont, par exemple, des développements de grille 10 à 30 fois plus faibles que le transistor T3.

Les première, seconde et troisième résistances R1, R2 et R3 ont, par exemple, respectivement des valeurs de 10 Ohms, 50 Ohms et 10 Ohms.

Ces valeurs dépendent bien entendu de nombreux facteurs tels que les transistors ou la technologie utilisée. Elles sont donc indiquées ici de manière illustrative et non limitative et l'homme du métier saura les adapter en fonction des caractéristiques du convertisseur.

La tension auxiliaire V_{AUX1} est, par exemple, de 3 V.

Il est à noter que les transistors HEMT à déplétion T1, T2 et T3 présentent l'avantage de pouvoir être utilisés en conduction directe et inverse, et ne nécessitent donc pas obligatoirement l'usage de diodes Schottky antiparallèles pour la gestion des courants inverses, ce qui permet de rendre minimales les capacités parasites dans le montage.

Différentes technologies de semi-conducteurs peuvent être utilisées pour la réalisation des transistors HEMT à déplétion T1, T2 et T3, ces matériaux étant principalement le nitrure de gallium (GaN) et l'arséniure de gallium (GaAs) mais aussi tout autre matériau semi-conducteur à base de matériaux du groupe III-V tels que AlGaN, AlN, InAlN, InAlGaN, etc.

Les diodes Schottky D1 et D2 peuvent être en technologie Si, SiC, GaAs ou GaN mais peuvent être également basées sur des matériaux semi-conducteurs à base de matériaux du groupe III-V tels que AlGaN, AlN, InAlN, InAlGaN, etc.

La tension d'entrée V_{IN1} au niveau de l'entrée du circuit de pilotage est négative et comprise entre 0 V et -Vp, Vp étant la tension de pincement du transistor de pilotage T1, ladite tension d'entrée V_{IN1} étant délivrée par un circuit d'interface (non représenté à la Figure 1) relié à un circuit numérique de commande PWM (modulation d'impulsions en largeur) ou sigma-delta (non représenté à la Figure 1).

Le circuit numérique de commande est l'un parmi un processeur de signal numérique (DSP), une matrice prédiffusée programmable par l'utilisateur (FPGA), un circuit intégré spécifique (ASIC) ou tout autre circuit numérique permettant de piloter le bloc convertisseur continu-continu.

Le circuit d'interface permet de fournir la tension d'entrée au circuit de pilotage à partir de la commande numérique fournie par le circuit numérique de commande.

Le circuit de pilotage du convertisseur continu-continu étant commandé par un signal numérique de type PWM ou sigma-delta, deux états sont possibles pour caractériser ce bloc convertisseur continu-continu.

Dans un premier état, désigné par « état d'extinction » dans lequel le signal numérique de commande impose une tension d'entrée V_{IN1} = 0 V, le transistor de pilotage T1 est fermé, la grille du transistor de pilotage T2 est mise à la masse ainsi que la borne de la seconde résistance R2 connectée au drain du transistor de pilotage T1, imposant ainsi un courant dans la seconde résistance R2 en provenance de l'alimentation auxiliaire V_{AUX1} à travers la diode D2. La tension résultante aux bornes de la seconde résistance R2 ouvre le transistor de pilotage T2 et la tension auxiliaire V_{AUX1} est appliquée à la grille du transistor de puissance à piloter T3. La diode de puissance D1 étant alors passante, la tension de sortie V_{OUT} du circuit de puissance abaisseur de tension est égale à la seconde tension d'alimentation VDD2, et la différence de tension entre V_{AUX1} et VDD2 ouvre le transistor de puissance T3. Ainsi, dans cet état, la consommation du circuit de pilotage est réduite au courant traversant la seconde résistance R2 et la diode D2 en provenance de la tension auxiliaire V_{AUX1}.

En raison du fait que les transistors utilisés sont des transistors HEMT hyperfréquences présentant des gains très importants, il existe un risque d'oscillation (d'instabilité) desdits transistors. Afin de contrôler ce risque, les première et troisième résistances R1 et R3 qui sont des résistances de stabilisation ont été positionnées sur les grilles du premier transistor de pilotage T1 et du transistor de puissance à piloter T3.

Dans un second état, désigné « état d'activation » dans lequel le signal numérique de commande impose une tension d'entrée V_{IN1} = - Vp, le transistor de pilotage T1 est ouvert. Le courant dans la seconde résistance R2 étant nul, la tension grille-source du transistor de pilotage T2 est égale à 0 V et le transistor de pilotage T2 est donc fermé, imposant ainsi la première tension d'alimentation VDD1 sur la grille du transistor de puissance T3 et bloquant la diode D2. Le transistor de puissance T3 est ainsi fermé, imposant la première tension d'alimentation VDD1 sur la tension de sortie V_{OUT} du circuit de puissance abaisseur de tension et bloquant la diode de puissance D1. Dans cet état, la diode D2 et le transistor de pilotage T1 étant bloqués, la consommation du circuit de pilotage de grille est nulle.

La seconde résistance R2 influe directement sur la vitesse de commutation du circuit de pilotage de grille. Pour un développement de grille de transistor de pilotage T2 donné, une valeur de seconde résistance R2 plus faible conduira à une vitesse de commutation accrue mais impliquera alors une consommation plus importante lorsque le transistor de puissance à piloter T3 sera ouvert. Il existe donc, pour un développement de grille de transistor de pilotage T2 donné, un compromis entre vitesse et consommation du circuit de pilotage.

Cependant, l'architecture du bloc convertisseur continu-continu présente l'avantage que les transistors de pilotage T1 et T2 de développements de grille très faibles vis-à-vis du développement de grille du transistor de puissance T3 suffisent à piloter T3 car il n'est pas nécessaire de fournir un fort courant pour piloter la grille du transistor de puissance T3. Ceci a pour avantage de minimiser significativement la capacité parasite grille-source du transistor de pilotage T2 qui sera ainsi très faible et donc permettra d'utiliser des valeurs de seconde résistance R2 suffisamment grandes pour que le circuit de pilotage consomme peu.

Tous les composants du convertisseur continu-continu sont soit des composants discrets montés sur une carte à circuits imprimés, soit intégrés de manière monolithique dans un circuit intégré.

Dans le cas d'une intégration de manière monolithique, cela peut permettre l'intégration du convertisseur continu-continu et d'un amplificateur RF de puissance alimenté par le convertisseur continu-continu dans une même technologie et donc intégrés sur une même puce, cette intégration pouvant directement être réalisée de manière monolithique dans un circuit de type MMIC afin d'augmenter l'intégration du convertisseur continu-continu.

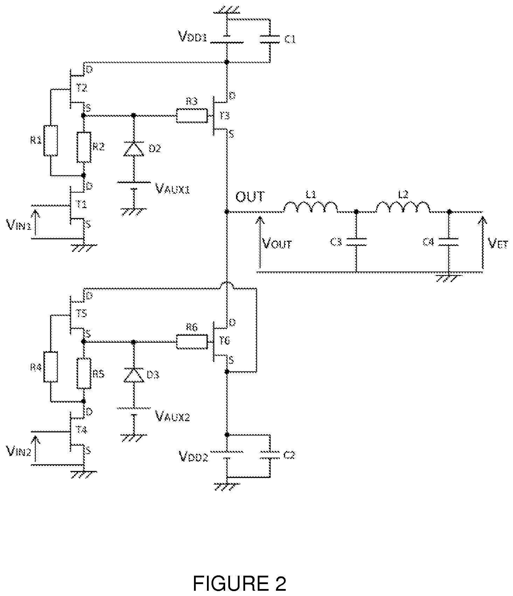

Si l'on se réfère à la Figure 2, on peut voir qu'il y est représenté un convertisseur continu-continu pour la technique de suivi d'enveloppe selon un second mode de réalisation de la présente invention.

Le convertisseur continu-continu pour la technique de suivi d'enveloppe selon le second mode de réalisation est identique au convertisseur continu-continu selon le premier mode de réalisation, à l'exception que le circuit de puissance abaisseur de tension du bloc convertisseur continu-continu selon le second mode de réalisation est de type synchrone et comprend un second transistor de puissance HEMT à déplétion T6 à la place de la diode de puissance D1 du premier mode de réalisation, la grille du second transistor de puissance T6 étant pilotée par une partie supplémentaire du circuit de pilotage, la source du second transistor de puissance T6 étant connectée à la seconde tension d'alimentation VDD2, la sortie OUT du circuit de puissance abaisseur de tension étant connectée à la source du premier transistor de puissance T3 et au drain du second transistor de puissance T6, et la grille du second transistor de puissance T6 étant connectée au circuit de pilotage du bloc convertisseur continu-continu, de telle sorte que la tension de sortie V_{OUT} du circuit de puissance abaisseur de tension du bloc convertisseur continu-continu est bornée par les première et seconde tensions d'alimentation VDD1 et VDD2.

Le circuit de pilotage comprend en outre une partie supplémentaire de pilotage de grille du second transistor de puissance T6 dont la structure est identique à celle de pilotage de grille du premier transistor de puissance T3 et comprenant un premier transistor de pilotage HEMT à déplétion T4, un second transistor de pilotage HEMT à déplétion T5, des première, seconde et troisième résistances R4, R5, R6, une diode Schottky D3 et une tension d'alimentation auxiliaire V_{AUX2}, la source du premier transistor de pilotage T4 étant connectée à la masse, le drain du premier transistor de pilotage T4 étant connecté à l'une des bornes de la première résistance R4 et à l'une des bornes de la seconde résistance R5, la grille du premier transistor de pilotage T4 étant connectée à une entrée V_{IN2} correspondante du circuit de pilotage, la grille du second transistor de pilotage T5 étant connectée à l'autre des bornes de la première résistance R4, la source du second transistor de pilotage T5 étant connectée à l'autre des bornes de la seconde résistance R5, à la cathode de la diode Schottky D3 et à l'une des bornes de la troisième résistance R6, l'anode de la diode Schottky D3 étant connectée à la tension d'alimentation auxiliaire V_{AUX2}, l'autre des bornes de la troisième résistance R6 étant connectée à la grille du transistor HEMT à déplétion T6 du circuit de puissance abaisseur de tension à piloter correspondant, le drain du second transistor de pilotage T5 étant connecté à la seconde tension d'alimentation VDD2, la tension d'alimentation auxiliaire V_{AUX2} étant supérieure à la tension de pincement du second transistor de pilotage T5, et la seconde tension d'alimentation VDD2 étant supérieure à la tension d'alimentation auxiliaire V_{AUX2} plus la tension de pincement du transistor HEMT à déplétion T6.

En pratique, Vₐᵤₓ₁ peut avantageusement être égale à Vₐᵤₓ₂.

La tension auxiliaire V_{AUX2} est, par exemple, de 3 V.

Les deux tensions d'entrée V_{IN1} et V_{IN2} du circuit de pilotage sont complémentaires, ce qui nécessite une commande numérique supplémentaire de type PWM ou sigma-delta inversée (ou complémentée) par rapport à la première commande numérique, de telle sorte que V_{IN2} = 0 V lorsque V_{IN1} = - V_{p_T1} V et V_{IN2} = -V_{p_T4} lorsque V_{IN1} = 0 V.

Le fonctionnement du transistor de puissance T3 et de sa partie de circuit de pilotage associée est identique à celui du premier mode de réalisation.

Le fonctionnement du transistor de puissance T6 et de sa partie de circuit de pilotage associée est similaire à celui du transistor de puissance T3. Cependant, ce transistor de puissance T6 est utilisé à l'état d'activation avec des tensions drain-source V_{DS} faiblement négatives et un courant drain-source I_{DS} négatif.

Dans ce bloc convertisseur continu-continu de type synchrone, l'état d'activation est défini comme étant l'état dans lequel le transistor de puissance T3 est fermé. Le transistor de puissance T6 est alors ouvert et la première tension d'alimentation VDD1 est appliquée sur la tension de sortie V_{OUT} du circuit de puissance abaisseur de tension du bloc convertisseur continu-continu. A l'inverse, à l'état d'extinction dans lequel le transistor de puissance T3 est ouvert, le transistor de puissance T6 est fermé et ainsi la seconde tension d'alimentation VDD2 est appliquée sur la tension de sortie V_{OUT} du circuit de puissance abaisseur de tension du bloc convertisseur continu-continu.

Il est à noter que le circuit numérique de commande peut être configuré pour compenser les différences de temps de montée et de descente, aussi appelés temps morts, entre les deux transistors de puissance T3 et T6.

Les transistors de puissance HEMT pouvant fonctionner en conduction directe ou inverse, c'est-à-dire suivant deux quadrants (V_{DS}, I_{DS}) > 0 ou (V_{DS}, I_{DS}) < 0, il en résulte que chaque transistor de puissance T3 ou T6, pour les topologies asynchrone et synchrone, peut être monté en inversant le drain et la source, le câblage du circuit de pilotage restant dans ces conditions inchangé. Dans le cas de la topologie synchrone, chacun des transistors de puissance T3 et T6 peut être inversé de manière indépendante de l'autre des transistors de puissance T3 et T6.

Il est à noter que les diodes de pilotage D2 et D3 pourraient être remplacées par des transistors de type HEMT de même technologie que les autres transistors du circuit, sans s'écarter du cadre de la présente invention.

Le convertisseur continu-continu pour la technique de suivi d'enveloppe selon la présente invention peut également être utilisé dans une architecture de convertisseur continu-continu de type multi-phase, c'est-à-dire utilisant en parallèle plusieurs convertisseurs continu-continu selon la présente invention avec en commun à chacun les deux tensions d'alimentation VDD1 et VDD2. Dans ces conditions, le convertisseur continu-continu de type multi-phase obtenu sera lui aussi particulièrement adapté pour la technique de suivi d'enveloppe, permettant de supporter des puissances totales de sortie plus élevées et d'améliorer la réjection de la fréquence de découpe dont l'importance d'une bonne réjection est primordiale pour les applications de suivi d'enveloppe.

L'invention a également pour objet un système pour la technique de suivi d'enveloppe comprenant un convertisseur continu-continu pour la technique de suivi d'enveloppe selon le premier mode de réalisation ou le second mode de réalisation de la présente invention, un amplificateur radiofréquence (RF) de puissance et un circuit numérique de traitement de suivi d'enveloppe, le circuit numérique de traitement de suivi d'enveloppe commandant le convertisseur continu-continu et l'amplificateur RF de puissance, et la sortie du convertisseur continu-continu étant reliée à l'entrée de tension d'alimentation de l'amplificateur RF de puissance.

Ainsi, la première tension d'alimentation VDD1 du convertisseur continu-continu correspond à la tension d'alimentation maximale de l'amplificateur RF de puissance lorsque celui-ci fournit une puissance de sortie maximale, et la seconde tension d'alimentation VDD2 du convertisseur continu-continu correspond à la tension d'alimentation minimale de l'amplificateur RF de puissance lorsque sa puissance de sortie est faible.

## Revendications

1. Bloc convertisseur continu-continu forte puissance supérieure à 1 W et haute fréquence supérieure à 10MHz pour la technique de suivi d'enveloppe pour des applications d'amplification radiofréquence et/ou hyperfréquence comprenant un circuit de puissance abaisseur de tension dont la sortie constitue la sortie du bloc convertisseur continu-continu configurée pour être reliée à une entrée de tension d'alimentation d'un amplificateur radiofréquence, RF, de puissance, le circuit de puissance abaisseur de tension comprenant au moins un transistor HEMT, à haute mobilité d'électrons, à déplétion (T3 ; T6), le bloc convertisseur continu-continu comprenant en outre un circuit de pilotage de grille de l'au moins un transistor HEMT à déplétion (T3 ; T6) du circuit de puissance abaisseur de tension, le circuit de pilotage comprend des transistors HEMT à déplétion (T1, T2 ; T4, T5) configurés pour piloter la grille de l'au moins un transistor HEMT à déplétion (T3 ; T6) du circuit de puissance abaisseur de tension, et **caractérisé par le fait que** le circuit de puissance abaisseur de tension est alimenté par deux tensions d'alimentation référencées à la masse, positives et non nulles, à savoir une première tension d'alimentation (VDD1) et une seconde tension d'alimentation (VDD2), la première tension d'alimentation (VDD1) étant supérieure à la seconde tension d'alimentation (VDD2).

2. Bloc convertisseur continu-continu selon la revendication 1, **caractérisé par le fait que** le circuit de puissance abaisseur de tension est de type asynchrone et comprend un transistor de puissance HEMT à déplétion (T3) et une diode de puissance Schottky (D1), la borne d'entrée de conduction du transistor de puissance (T3) étant connectée à la première tension d'alimentation (VDD1), l'anode de la diode de puissance (D1) étant connectée à la seconde tension d'alimentation (VDD2), la sortie (OUT) du circuit de puissance abaisseur de tension étant connectée à la borne de sortie de conduction du transistor de puissance (T3) et à la cathode de la diode de puissance (D1), et la grille du transistor de puissance (T3) étant connectée au circuit de pilotage du bloc convertisseur continu-continu, de telle sorte que la tension de sortie (V_{OUT}) du circuit de puissance abaisseur de tension du bloc convertisseur continu-continu est bornée par les première et seconde tensions d'alimentation (VDD1, VDD2).

3. Bloc convertisseur continu-continu selon la revendication 1, **caractérisé par le fait que** le circuit de puissance abaisseur de tension est de type synchrone et comprend un premier transistor de puissance HEMT à déplétion (T3) et un second transistor de puissance HEMT à déplétion (T6), la borne d'entrée de conduction du premier transistor de puissance (T3) étant connectée à la première tension d'alimentation (VDD1), la borne de sortie de conduction du second transistor de puissance (T6) étant connectée à la seconde tension d'alimentation (VDD2), la sortie (OUT) du circuit de puissance abaisseur de tension étant connectée à la borne de sortie de conduction du premier transistor de puissance (T3) et à la borne d'entrée de conduction du second transistor de puissance (T6), et les grilles des premier (T3) et second (T6) transistors de puissance étant connectées au circuit de pilotage du bloc convertisseur continu-continu, de telle sorte que la tension de sortie (V_{OUT}) du circuit de puissance abaisseur de tension du bloc convertisseur continu-continu est bornée par les première et seconde tensions d'alimentation (VDD1, VDD2).

4. Bloc convertisseur continu-continu selon l'une des revendications 1 à 3, **caractérisé par le fait qu'**il comprend en outre des condensateurs de découplage d'alimentation (C1, C2) respectivement disposés en parallèle des première et seconde tensions d'alimentation (VDD1, VDD2).

5. Bloc convertisseur continu-continu selon l'une des revendications 1 à 4, **caractérisé par le fait que** le circuit de pilotage comprend, pour chaque grille de transistor HEMT à déplétion (T3 ; T6) du circuit de puissance abaisseur de tension à piloter, un premier transistor de pilotage HEMT à déplétion (T1 ; T4), un second transistor de pilotage HEMT à déplétion (T2 ; T5), des première, seconde et troisième résistances (R1, R2, R3 ; R4, R5, R6), une diode Schottky (D2 ; D3) et une tension d'alimentation auxiliaire (V_{AUX1} ; V_{AUX2}), la source du premier transistor de pilotage (T1 ; T4) étant connectée à la masse, le drain du premier transistor de pilotage (T1 ; T4) étant connectée à l'une des bornes de la première résistance (R1 ; R4) et à l'une des bornes de la seconde résistance (R2 ; R5), la grille du premier transistor de pilotage (T1 ; T4) étant connectée à une entrée (V_{IN1} ; V_{IN2}) correspondante du circuit de pilotage, la grille du second transistor de pilotage (T2 ; T5) étant connectée à l'autre des bornes de la première résistance (R1 ; R4), la source du second transistor de pilotage (T2 ; T5) étant connectée à l'autre des bornes de la seconde résistance (R2 ; R5), à la cathode de la diode Schottky (D2 ; D3) et à l'une des bornes de la troisième résistance (R3 ; R6), l'anode de la diode Schottky (D2 ; D3) étant connectée à la tension d'alimentation auxiliaire (V_{AUX1} ; V_{AUX2}), l'autre des bornes de la troisième résistance (R3 ; R6) étant connectée à la grille du transistor HEMT à déplétion (T3 ; T6) du circuit de puissance abaisseur de tension à piloter correspondant, le drain du second transistor de pilotage (T2 ; T5) étant connectée à la première tension d'alimentation (VDD1) si celle-ci est connectée à la borne d'entrée de conduction du transistor HEMT à déplétion (T3 ; T6) du circuit de puissance abaisseur de tension à piloter correspondant ou étant connectée à la seconde tension d'alimentation (VDD2) si celle-ci est connectée à la borne de sortie de conduction du transistor HEMT à déplétion (T3 ; T6) du circuit de puissance abaisseur de tension à piloter correspondant, la tension d'alimentation auxiliaire (V_{AUX1} ; V_{AUX2}) étant supérieure à la tension de pincement du second transistor de pilotage (T2 ; T5), et la seconde tension d'alimentation (VDD2) étant supérieure à la tension d'alimentation auxiliaire (V_{AUX1} ; V_{AUX2}) plus la tension de pincement du transistor HEMT à déplétion (T3 ; T6) du circuit de puissance abaisseur de tension à piloter correspondant.

6. Bloc convertisseur continu-continu selon la revendication 5, **caractérisé par le fait que** chaque tension d'entrée (V_{IN1} ; V_{IN2}) au niveau d'une entrée correspondante du circuit de pilotage est négative et comprise entre 0 V et -Vp, Vp étant la tension de pincement du transistor de pilotage dont la grille est connectée à ladite entrée correspondante du circuit de pilotage, ladite tension d'entrée (V_{IN1} ; V_{IN2}) étant délivrée par un circuit d'interface relié à un circuit numérique de commande PWM, modulation d'impulsions en largeur, ou sigma-delta.

7. Bloc convertisseur continu-continu selon la revendication 5 ou la revendication 6, **caractérisé par le fait que**, lorsque le circuit de puissance abaisseur de tension est de type synchrone, les deux tensions d'entrée (V_{IN1}, V_{IN2}) du circuit de pilotage sont complémentaires.

8. Bloc convertisseur continu-continu selon l'une des revendications 1 à 7, **caractérisé par le fait que** les tailles de grille des transistors HEMT à déplétion (T1, T2, T4, T5) du circuit de pilotage sont inférieures à celles du ou des transistors HEMT à déplétion (T3, T6) du circuit de puissance abaisseur de tension.

9. Bloc convertisseur continu-continu selon l'une des revendications 1 à 8, **caractérisé par le fait que** tous les composants du bloc convertisseur continu-continu sont des composants discrets montés sur une carte à circuits imprimés ou liés à celle-ci par des fils de liaison.

10. Bloc convertisseur continu-continu selon l'une des revendications 1 à 8, **caractérisé par le fait que** tous les composants du bloc convertisseur continu-continu sont intégrés de manière monolithique dans un circuit intégré.

11. Bloc convertisseur continu-continu selon l'une des revendications 1 à 10, **caractérisé par le fait que** les transistors HEMT (T3, T6) du circuit de puissance abaisseur de tension et les transistors HEMT (T1, T2 ; T4, T5) du circuit de pilotage sont en l'un quelconque parmi le nitrure de gallium, GaN, l'arséniure de gallium, GaAs, ou en tout autre matériau semi-conducteur à base de matériaux de type III-V.

12. Bloc convertisseur continu-continu selon l'une des revendications 1 à 11, **caractérisé par le fait que** les diodes (D1, D2, D3) sont de type Schottky en technologie Si, SiC, GaAs, GaN ou en tout autre matériau semi-conducteur à base de matériaux de type III-V.

13. Convertisseur continu-continu pour la technique de suivi d'enveloppe, **caractérisé par le fait qu'**il comprend un bloc convertisseur continu-continu selon l'une des revendications 1 à 12 et un filtre de sortie connecté à la sortie du circuit de puissance abaisseur de tension du bloc convertisseur continu-continu, le filtre étant de préférence à base de condensateurs et d'inductances, la sortie du filtre de sortie constituant la sortie du convertisseur continu-continu.

14. Convertisseur continu-continu pour la technique de suivi d'enveloppe de type multi-phase, **caractérisé par le fait qu'**il comprend au moins deux convertisseurs continu-continu selon la revendication 13 montés en parallèle et alimentés par les mêmes tensions d'alimentation (VDD1) et (VDD2).

15. Système pour la technique de suivi d'enveloppe, **caractérisé par le fait qu'**il comprend un convertisseur continu-continu pour la technique de suivi d'enveloppe selon la revendication 13 ou un convertisseur continu-continu pour la technique de suivi d'enveloppe de type multiphase selon la revendication 14, un amplificateur radiofréquence, RF, de puissance et un circuit numérique de traitement de suivi d'enveloppe, le circuit numérique de traitement de suivi d'enveloppe étant configuré pour commander le convertisseur continu-continu et l'amplificateur RF de puissance, et la sortie du convertisseur continu-continu étant reliée à l'entrée de tension d'alimentation de l'amplificateur RF de puissance.

## Patentansprüche

1. Gleichstromwandlerblock Hochwattleistung über 1 W und Hochfrequenz über 10 MHz für die Hüllkurvennachführungstechnik für Funkfrequenz- und/oder Hyperfrequenzverstärkungsanwendungen, umfassend einen Abwärtswandler-Leistungsschaltkreis, dessen Ausgang den Ausgang des Gleichstromwandlerblocks bildet, der konfiguriert ist, um mit einem Versorgungsspannungs-Eingang eines RF-Funkfrequenz-Leistungsverstärkers verbunden zu sein, wobei der Abwärtswandler-Leistungsschaltkreis mindestens einen HEMT-Transistor mit hoher Elektronenbeweglichkeit vom Verarmungstyp (T3; T6) umfasst, wobei der Gleichstromwandlerblock ferner einen Gate-Pilotkreis des mindestens einen HEMT-Transistor vom Verarmungstyp (T3; T6) des Abwärtswandler-Leistungsschaltkreises umfasst, wobei der Pilotkreis HEMT-Transistoren vom Verarmungstyp (T1, T2; T4, T5) umfasst, die konfiguriert sind, um das Gate des mindestens einen HEMT-Transistors vom Verarmungstyp (T3; T6) des Abwärtswandler-Leistungsschaltkreises zu steuern, und **dadurch gekennzeichnet, dass** der Abwärtswandler-Leistungsschaltkreis von zwei massebezogenen Versorgungsspannungen versorgt wird, die positiv und nicht null sind, nämlich einer ersten Versorgungsspannung (VDD1) und einer zweiten Versorgungsspannung (VDD2), wobei die erste Versorgungsspannung (VDD1) höher als die zweite Versorgungsspannung (VDD2) ist.

2. Gleichstromwandlerblock nach Anspruch 1, **dadurch gekennzeichnet, dass** der Abwärtswandler-Leistungsschaltkreis vom asynchronen Typ ist und einen HEMT-Leistungstransistor vom Verarmungstyp (T3) und eine Schottky-Leistungsdiode (D1) umfasst, wobei die Leitungs-Eingangsklemme des Leistungstransistors (T3) an die erste Versorgungsspannung (VDD1) angeschlossen ist, wobei die Anode der Leistungsdiode (D1) an die zweite Versorgungsspannung (VDD2) angeschlossen ist, wobei der Ausgang (OUT) des Abwärtswandler-Leistungsschaltkreises an die Leitungs-Ausgangsklemme des Leistungstransistors (T3) und an die Kathode der Leistungsdiode (D1) angeschlossen ist und das Gate des Leistungstransistors (T3) an den Pilotkreis des Gleichstromwandlerblocks angeschlossen ist, so dass die Ausgangsspannung (V_{OUT}) des Abwärtswandler-Leistungsschaltkreises des Gleichstromwandlerblocks durch die erste und zweite Versorgungsspannung (VDD1, VDD2) beschränkt ist.

3. Gleichstromwandlerblock nach Anspruch 1, **dadurch gekennzeichnet, dass** der Abwärtswandler-Leistungsschaltkreis vom synchronen Typ ist und einen ersten HEMT-Leistungstransistor vom Verarmungstyp (T3) und einen zweiten HEMT-Leistungstransistor vom Verarmungstyp (T6) umfasst, wobei die Leitungs-Eingangsklemme des ersten Leistungstransistors (T3) an die erste Versorgungsspannung (VDD1) angeschlossen ist, wobei die Leitungs-Ausgangsklemme des zweiten Leistungstransistors (T6) an die zweite Versorgungsspannung (VDD2) angeschlossen ist, wobei der Ausgang (OUT) des Abwärtswandler-Leistungsschaltkreises an die Leitungs-Ausgangsklemme des ersten Leistungstransistors (T3) und an die Leitungs-Eingangsklemme des zweiten Leistungstransistors (T6) angeschlossen ist und die Gates des ersten (T3) und zweiten (T6) Leistungstransistors an den Pilotkreis des Gleichstromwandlerblocks angeschlossen sind, so dass die Ausgangsspannung (V_{OUT}) des Abwärtswandler-Leistungsschaltkreises des Gleichstromwandlerblocks durch die erste und zweite Versorgungsspannung (VDD1, VDD2) beschränkt ist.

4. Gleichstromwandlerblock nach einem der Ansprüche 1 bis 3, **dadurch gekennzeichnet, dass** er ferner Versorgungs-Entkopplungskondensatoren (C1, C2) umfasst, die jeweils parallel zu der ersten und zweiten Versorgungsspannung (VDD1, VDD2) angeordnet sind.

5. Gleichstromwandlerblock nach einem der Ansprüche 1 bis 4, **dadurch gekennzeichnet, dass** der Pilotkreis für jedes Gate eines HEMT-Transistor vom Verarmungstyp (T3; T6) des zu steuernden Abwärtswandler-Leistungsschaltkreises einen ersten HEMT-Pilottransistor vom Verarmungstyp (T1; T4), einen zweiten HEMT-Pilottransistor vom Verarmungstyp (T2; T5), einen ersten, zweiten und dritten Widerstand (R1, R2 , R3; R4, R5, R6), eine Schottky-Diode (D2; D3) und eine Hilfs-Versorgungsspannung (V_{AUX1}; V_{AUX2}) umfasst, wobei die Quelle des ersten Pilottransistors (T1; T4) an die Masse angeschlossen ist, wobei der Drain des ersten Pilottransistors (T1; T4) an eine der Klemmen des ersten Widerstands (R1; R4) und an eine der Klemmen des zweiten Widerstands (R2; R5) angeschlossen ist, wobei das Gate des ersten Pilottransistors (T1; T4) an einen entsprechenden Eingang (V_{IN1}; V_{IN2}) des Pilotkreises angeschlossen ist, wobei das Gate des zweiten Pilottransistors (T2; T5) an die andere der Klemmen des ersten Widerstands (R1; R4) angeschlossen ist, wobei die Quelle des zweiten Pilottransistors (T2; T5) an die andere der Klemmen des zweiten Widerstands (R2; R5), an die Kathode der Schottky-Diode (D2; D3) und an eine der Klemmen des dritten Widerstands (R3; R6) angeschlossen ist, wobei die Anode der Schottky-Diode (D2; D3) an die Hilfs-Versorgungsspannung (V_{AUX1}; V_{AUX2}) angeschlossen ist, wobei die andere der Klemmen des dritten Widerstands (R3; R6) an das Gate des HEMT-Transistors vom Verarmungstyp (T3; T6) des entsprechenden zu steuernden Abwärtswandler-Leistungsschaltkreis angeschlossen ist, wobei der Drain des zweiten Pilottransistors (T2; T5) an die erste Versorgungsspannung (VDD1) angeschlossen ist, wenn diese an die Leitungs-Eingangsklemme des HEMT-Transistors vom Verarmungstyp (T3; T6) des entsprechenden zu steuernden Abwärtswandler-Leistungsschaltkreises angeschlossen ist oder an die zweite Versorgungsspannung (VDD2) angeschlossen ist, wenn diese an die Leitungs-Ausgangsklemme des HEMT-Transistors vom Verarmungstyp (T3; T6) des entsprechenden zu steuernden Abwärtswandler-Leistungsschaltkreises angeschlossen ist, wobei die Hilfs-Versorgungsspannung (V_{AUX1}; V_{AUX2}) höher als die Klemmspannung des zweiten Pilottransistors (T2; T5) ist und die zweite Versorgungsspannung (VDD2) höher als die Hilfs-Versorgungsspannung (V_{AUX1}; V_{AUX2}) zuzüglich der Klemmspannung des HEMT-Transistors vom Verarmungstyp (T3; T6) des entsprechenden zu steuernden Abwärtswandler-Leistungsschaltkreises ist.

6. Gleichstromwandlerblock nach Anspruch 5, **dadurch gekennzeichnet, dass** jede Eingangsspannung (V_{IN1}; V_{IN2}) im Bereich eines entsprechenden Eingangs des Pilotkreises negativ ist und zwischen 0 V und -Vp liegt, wobei Vp die Klemmspannung des Pilottransistors ist, dessen Gate an den entsprechenden Eingang des Pilotkreises angeschlossen ist, wobei die Eingangsspannung (V_{IN1}; V_{IN2}) von einem Schnittstellenkreis bereitgestellt wird, der mit einem digitalen PWM-(Pulsweitenmodulation) oder Sigma-Delta-Steuerkreis verbunden ist.

7. Gleichstromwandlerblock nach Anspruch 5 oder Anspruch 6, **dadurch gekennzeichnet, dass**, wenn der Abwärtswandler-Leistungsschaltkreis vom Typ synchron ist, die zwei Eingangsspannungen (V_{IN1}, V_{IN2}) des Pilotkreises komplementär sind.

8. Gleichstromwandlerblock nach einem der Ansprüche 1 bis 7, **dadurch gekennzeichnet, dass** die Gategrößen der HEMT-Transistoren vom Verarmungstyp (T1, T2, T4, T5) des Pilotkreises kleiner sind als die des oder der HEMT-Transistoren vom Verarmungstyp (T3, T6) des Abwärtswandler-Leistungsschaltkreises.

9. Gleichstromwandlerblock nach einem der Ansprüche 1 bis 8, **dadurch gekennzeichnet, dass** alle Bauteile des Gleichstromwandlerblocks diskrete Bauteile sind, die auf einer gedruckten Schaltkreiskarte angebracht oder mit dieser anhand von Verbindungsdrähten verbunden sind.

10. Gleichstromwandlerblock nach einem der Ansprüche 1 bis 8, **dadurch gekennzeichnet, dass** alle Bauteile des Gleichstromwandlerblocks monolithisch in einen integrierten Schaltkreis integriert sind.

11. Gleichstromwandlerblock nach einem der Ansprüche 1 bis 10, **dadurch gekennzeichnet, dass** die HEMT-Transistoren (T3, T6) des Abwärtswandler-Leistungsschaltkreises und die HEMT-Transistoren (T1, T2; T4, T5) des Pilotkreises aus einem von dem Galliumnitrid (GaN), dem Galliumarsenid (GaAs) oder aus jedem anderen halbleitenden Material auf der Basis von Materialien des Typs III-V sind.

12. Gleichstromwandlerblock nach einem der Ansprüche 1 bis 11, **dadurch gekennzeichnet, dass** die Dioden (D1, D2, D3) vom Schottky-Typ aus Si-, Sic-, GaAs-, GaN-Technologie oder aus jedem anderen halbleitenden Material auf der Basis von Materialien vom Typ III-V sind.

13. Gleichstromwandler für die Hüllkurvennachführungstechnik, **dadurch gekennzeichnet, dass** er einen Gleichstromwandlerblock nach einem der Ansprüche 1 bis 12 und einen Ausgangsfilter umfasst, der an den Ausgang des Abwärtswandler-Leistungsschaltkreises des Gleichstromwandlerblocks angeschlossen ist, wobei der Filter vorzugsweise auf der Basis von Kondensatoren und Induktanzen ist, wobei der Ausgang des Ausgangsfilters den Ausgang des Gleichstromwandlers bildet.

14. Gleichstromwandler für die Hüllkurvennachführungstechnik von Typ Mehrphasen, **dadurch gekennzeichnet, dass** er mindestens zwei Gleichstromwandler nach Anspruch 13 umfasst, die parallel montiert sind von denselben Versorgungsspannungen (VDD1) und (VDD2) versorgt werden.

15. System für die Hüllkurvennachführungstechnik, **dadurch gekennzeichnet, dass** es einen Gleichstromwandler für die Hüllkurvennachführungstechnik nach Anspruch 13 oder einen Gleichstromwandler für die Hüllkurvennachführungstechnik vom Typ Mehrphasen nach Anspruch 14, einen RF-Funkfrequenz-Leistungsverstärker und einen digitalen Hüllkurvennachführungs-Verarbeitungskreis umfasst, wobei der digitale Hüllkurvennachführungs-Verarbeitungskreis konfiguriert ist, um den Gleichstromwandler und den RF-Leistungsverstärker zu steuern und der Ausgang des Gleichstromwandlers mit dem Versorgungsspannungseingang des RF-Leistungsverstärkers verbunden ist.

## Claims

1. A high power higher than 1 W and high frequency higher than 10 MHz DC-DC converter block for the envelope tracking technique for radiofrequency and/or microwave amplification applications, comprising a step-down power circuit whose output constitutes the output of the DC-DC converter block configured to be connected to a power supply voltage input of a radiofrequency (RF) power amplifier, the step-down power circuit comprising at least one HEMT, high electron mobility transistors, depletion-mode transistor (T3; T6), the DC-DC converter block further comprising a gate driving circuit of the at least one HEMT depletion-mode transistor (T3, T6) of the step-down power circuit, the driving circuit comprising HEMT depletion-mode transistors (T1, T2; T4, T5) configured to drive the gate of the at least one HEMT depletion-mode transistor (T3; T6) of the step-down power circuit, and **characterized in that** the step-down power circuit is powered by two positive and non-zero power supply voltages referenced to ground, namely a first power supply voltage (VDD1) and a second power supply voltage (VDD2), the first power supply voltage (VDD1) being greater than the second power supply voltage (VDD2).

2. The DC-DC converter block according to claim 1, **characterized in that** the step-down power circuit is of asynchronous type and comprises a HEMT depletion-mode power transistor (T3) and a Schottky power diode (D1), the conduction input terminal of the power transistor (T3) being connected to the first power supply voltage (VDD1), the anode of the power diode (D1) being connected to the second power supply voltage (VDD2), the output (OUT) of the step-down power circuit being connected to the conduction output terminal of the power transistor (T3) and to the cathode of the power diode (D1), and the gate of the power transistor (T3) being connected to the driving circuit of the DC-DC converter block, such that the output voltage (V_{OUT}) of the step-down power circuit of the DC-DC converter block is bounded by the first and second power supply voltages (VDD1, VDD2).

3. The DC-DC converter block according to claim 1, **characterized in that** the step-down power circuit is of synchronous type and comprises a first HEMT depletion-mode power transistor (T3) and a second HEMT depletion-mode power transistor (T6), the conduction input terminal of the first power transistor (T3) being connected to the first power supply voltage (VDD1), the conduction output terminal of the second power transistor (T6) being connected to the second power supply voltage (VDD2), the output (OUT) of the step-down power circuit being connected to the conduction output terminal of the first power transistor (T3) and to the conduction input terminal of the second power transistor (T6), and the gates of the first (T3) and second (T6) power transistors being connected to the driving circuit of the DC-DC converter block, such that the output voltage (V_{OUT}) of the step-down power circuit of the DC-DC converter block is bounded by the first and second power supply voltages (VDD1, VDD2).

4. The DC-DC converter block according to one of claims 1 to 3, **characterized in that** it further comprises power supply decoupling capacitors (C1, C2) respectively arranged in parallel to the first and second power supply voltages (VDD1, VDD2).

5. The DC-DC converter block according to one of claims 1 to 4, **characterized in that** the driving circuit comprises, for each gate of HEMT depletion-mode transistor (T3; T6) of the step-down power circuit to be driven, a first HEMT depletion-mode drive transistor (T1; T4), a second HEMT depletion-mode drive transistor (T2; T5), first, second and third resistors (R1, R2, R3; R4, R5, R6), a Schottky diode (D2; D3) and an auxiliary power supply voltage (V_{AUX1}; V_{AUX2}), the source of the first drive transistor (T1; T4) being connected to the ground, the drain of the first drive transistor (T1; T4) being connected to one of the terminals of the first resistor (R1; R4) and to one of the terminals of the second resistor (R2; R5), the gate of the first drive transistor (T1; T4) being connected to a corresponding input (V_{IN1}; V_{IN2}) of the driving circuit, the gate of the second drive transistor (T2; T5) being connected to the other of the terminals of the first resistor (R1; R4), the source of the second drive transistor (T2; T5) being connected to the other of the terminals of the second resistor (R2; R5), to the cathode of the Schottky diode (D2; D3) and to one of the terminals of the third resistor (R3; R6), the anode of the Schottky diode (D2; D3) being connected to the auxiliary power supply voltage (V_{AUX1}; V_{AUX2}), the other of the terminals of the third resistor (R3; R6) being connected to the gate of the HEMT depletion-mode transistor (T3; T6) of the corresponding to-be-driven step-down power circuit, the drain of the second drive transistor (T2; T5) being connected to the first power supply voltage (VDD1) if the latter is connected to the conduction input terminal of the HEMT depletion-mode transistor (T3; T6) of the corresponding to-be-driven step-down power circuit or being connected to the second power supply voltage (VDD2) if the latter is connected to the conduction output terminal of the HEMT depletion-mode transistor (T3; T6) of the corresponding to-be-driven step-down power circuit, the auxiliary power supply voltage (V_{AUX1}; V_{AUX2}) being greater than the pinch-off voltage of the second drive transistor (T2; T5), and the second power supply voltage (VDD2) being higher than the auxiliary power supply voltage (V_{AUX1}; V_{AUX2}) plus the pinch-off voltage of the HEMT depletion-mode transistor (T3; T6) of the corresponding to-be-driven step-down power circuit.

6. The DC-DC converter block according to claim 5, **characterized in that** each input voltage (V_{IN1}; V_{IN2}) at a corresponding input of the driving circuit is negative and between 0 V and -Vp, Vp being the pinch-off voltage of the drive transistor whose gate is connected to said corresponding input of the driving circuit, said input voltage (V_{IN1}; V_{IN2}) being output by an interface circuit connected to a sigma-delta or PWM (pulse-width modulation) control digital circuit.

7. The DC-DC converter block according to claim 5 or claim 6, **characterized in that**, when the step-down power circuit is of synchronous type, both input voltages (V_{IN1}; V_{IN2}) of the driving circuit are complementary.

8. The DC-DC converter block according to one of claims 1 to 7, **characterized in that** the sizes of gate of the HEMT depletion-mode transistors (T1, T2, T4, T5) of the driving circuit are smaller than those of the at least one HEMT depletion-mode transistor (T3, T6) of the step-down power circuit.

9. The DC-DC converter block according to one of claims 1 to 8, **characterized in that** all components of the DC-DC converter block are discrete components mounted on a printed circuit board or connected thereto by link wires.

10. The DC-DC converter block according to one of claims 1 to 8, **characterized in that** all components of the DC-DC converter block are monolithically integrated on an integrated circuit.

11. The DC-DC converter block according to one of claims 1 to 10, **characterized in that** the HEMT transistors (T3, T6) of the step-down power circuit and the HEMT transistors (T1,T2; T4,T5) of the driving circuit are made of any one of gallium nitride (GaN), gallium arsenide (GaAs) or any other semiconductor material with materials of the group III-V.

12. The DC-DC converter block according to one of claims 1 to 11, **characterized in that** the diodes (D1,D2,D3) are of Schottky type and made of Si, SiC, GaAs, GaN or any other semiconductor material with materials of the group III-V.

13. A DC-DC converter for the envelope tracking technique, **characterized in that** it comprises a DC-DC converter block according to one of claims 1 to 12 and an output filter connected to the output of the step-down power circuit of the DC-DC converter block, the filter preferably comprising capacitors and inductors, the output of the output filter constituting the output of the DC-DC converter.

14. The multi-phase DC-DC converter for the envelope tracking technique, **characterized in that** it comprises at least two DC-DC converters according to claim 13 mounted in parallel and supplied by the same power supply voltages (VDD1) and (VDD2).

15. A system for the envelope tracking technique, **characterized in that** it comprises a DC-DC converter for the envelope tracking technique according to claim 13 or a multi-phase DC-DC converter for the envelope tracking technique according to claim 14, a radiofrequency (RF) power amplifier and an envelope tracking processing digital circuit, the envelope tracking processing digital circuit being configured to control the DC-DC converter and the RF power amplifier, and the output of the DC-DC converter being connected to the power supply voltage input of the RF power amplifier.
